## Europäisches Patentamt
## European Patent Office
## Office européen des brevets

(19)

(11) Numéro de publication: **0 064 424**
**B1**

(12)
# FASCICULE DE BREVET EUROPEEN

(45) Date de publication du fascicule du brevet:
**20.06.84**

(51) Int. Cl.³: **D 06 F 75/26,** H 05 K 7/20

(21) Numéro de dépôt: **82400532.6**

(22) Date de dépôt: **24.03.82**

(54) **Dissipateur thermique pour circuit électronique de fer à repasser et fer à repasser s'y rapportant.**

(30) Priorité: **10.04.81 LU 83292**

(43) Date de publication de la demande:
**10.11.82 Bulletin 82/45**

(45) Mention de la délivrance du brevet:
**20.06.84 Bulletin 84/25**

(84) Etats contractants désignés:
**BE CH DE FR GB IT LI NL SE**

(56) Documents cités:
**EP - A - 0 024 613**
**FR - A - 2 396 489**
**GB - A - 1 068 419**
**US - A - 4 103 737**

(73) Titulaire: **SEB S.A., F-21260 Selongey (FR)**

(72) Inventeur: **Schwob, Pierre, 55 avenue des Frères Lumière, F-69008 Lyon (FR)**

(74) Mandataire: **Bouju, André, 38 Avenue de la Grande Armée, F-75017 Paris (FR)**

Description

La présente invention concerne un dissipateur thermique pour circuit électronique de fer à repasser.

L'invention concerne également un fer à repasser utilisant un tel dissipateur.

Les circuits de régulation électronique comprennent normalement un étage de coupure, qui est souvent un triac, ainsi qu'une résistance dite «chutrice», destinée à procurer une chute de tension. De tels éléments sont générateurs de chaleur et, pour la bonne tenue des composants semi-conducteurs, cette chaleur doit être évacuée.

A cette fin, il est connu d'utiliser des dissipateurs de chaleur qui sont des pièces métalliques absorbant la chaleur produite et l'évacuant dans l'air ambiant par convection et rayonnement. Dans ce but, ils sont munis d'aillettes et présentent un état de surface ayant un bon pouvoir émissif (EP-A-24613).

Toutefois, dans les fers à repasser, la place est en général trop réduite pour loger un tel dissipateur. En outre, la proximité inévitable de la source de chaleur utile crée une difficulté supplémentaire qui amène à créer une protubérance sur la carrosserie pour y loger le dissipateur.

Le but de la présente invention est de réaliser un dissipateur qui, tout en conservant son efficacité, présente un faible encombrement permettant de le loger dans la carrosserie d'un fer à repasser classique.

Suivant l'invention, le dissipateur thermique pour circuit électronique comprenant au moins un élément générateur de chaleur tel qu'un triac ou une résistance chutrice comprend lui-même une enveloppe tubulaire qui contient ledit circuit électronique. Il est caractérisé en ce que ladite enveloppe tubulaire est métallique et est logée dans la poignée du fer. La section interne de cette poignée présente une section homologue à la section externe de l'enveloppe tubulaire, et une liaison thermique est disposée entre ladite enveloppe et la poignée du fer.

La dissipation de chaleur s'effectue par conduction, à travers la poignée vers la main de l'opérateur qui n'en subit aucune gêne, et sans provoquer aucun encombrement supplémentaire.

De préférence, la liaison thermique est réalisée par une feuille métallique gaufrée insérée entre le tube et la poignée, ou par l'interposition d'une graisse à base de silicones.

D'autres particularités et avantages de l'invention ressortiront de la description qui suit.

Aux dessins annexés, donnés à titre d'exemple non limitatif,

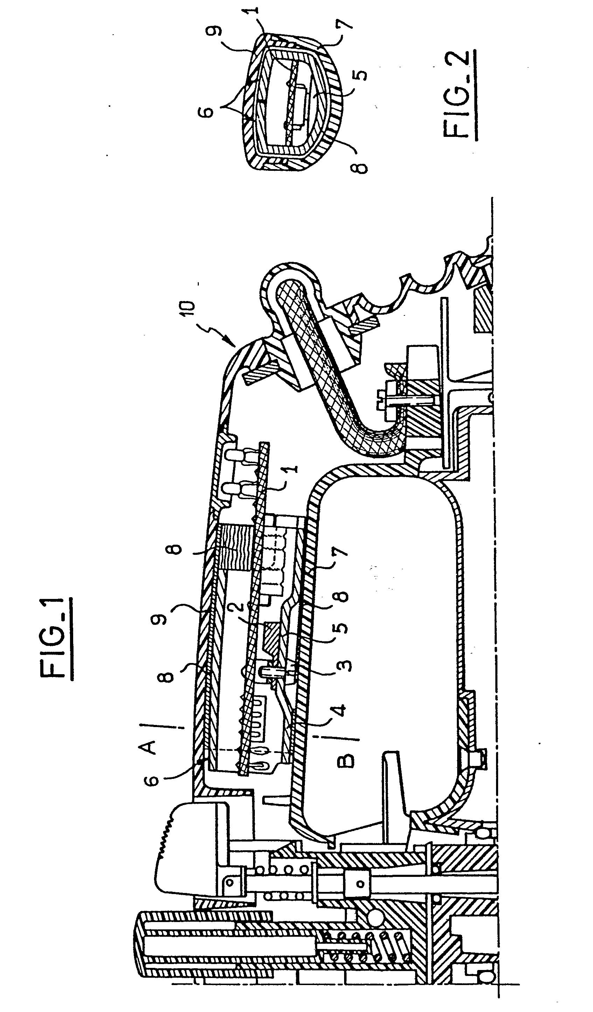

la figure 1 est une vue en coupe longitudinale partielle d'un fer à repasser conforme à l'invention,

la figure 2 est une vue en coupe de la poignée suivant AB de la figure 1,

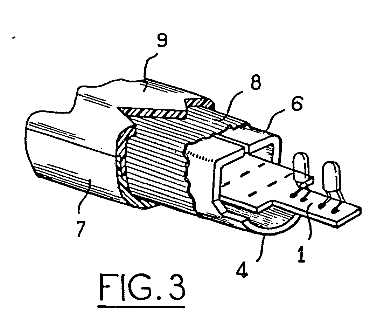

la figure 3 est une vue en coupe arrachée de la poignée.

En référence à ces figures, une plaquette isolante 1 du circuit imprimé porte un triac 2. Ce triac est fixé à l'aide d'une vis 3 à une tôle d'aluminium 4 constituant le dissipateur thermique. Cette tôle est emboutie et repliée pour former une enveloppe tubulaire 6 dans laquelle se situe la plaquette 1 supportant les composants électroniques. Un plat 5 est formé par emboutissage pour loger la tête de la vis 3.

La forme extérieure de l'enveloppe 6, est homologue à la forme intérieure d'une poignée 7, 9 d'un fer à repasser 10, dans laquelle elle est logée en laissant un faible jeu permettant l'insertion d'une tôle fine en aluminium gaufrée 8. Lors de la mise en place du sous-ensemble 1, 6, celui-ci est roulé dans la tôle fine gaufrée 8 et insérée à force dans une partie fixe 7 de la poignée; puis une partie amovible 9 de celle-ci est mise en place et vient presser énergiquement l'ensemble inséré. Cette manière d'opérer écrase plus ou moins les gaufrages de la tôle fine 8. Ce contact permanent sur une grande surface intérieure de la poignée facilité la transmission thermique vers l'extérieur et assure une évacuation satisfaisante des calories sans pour cela que la préhension du fer donne une sensation de chaleur inconfortable.

Si une résistance chutrice fait partie du circuit électronique, la chaleur produite par celle-ci est transmise à la masse métallique de l'enveloppe 6 par rayonnement et convection.

Il serait également possible de prévoir une forme extérieure de l'enveloppe tubulaire 6 tel qu'il s'encastre exactement dans la poignée 7, 9. Compte tenu des tolérances dimensionnelles des pièces, le contact thermique est plus aléatoire que si l'on ménage un certain jeu que l'on comble à l'aide d'un matériau bon conducteur, déformable et résilient.

Bien entendu l'invention ne se limite pas à l'exemple décrit, mais couvre toutes variantes minimes à la portée de l'homme de l'art. C'est ainsi que la feuille d'aluminium gaufrée 8 peut être remplacée par tout autre matériau tel que laiton, cuivre ou tout autre composant thermoconducteur métallique ou non dont les caractéristiques mécaniques ou thermiques répondent aux besoins.

Un mode de réalisation particulièrement intéressant lorsque les formes intérieures de la poignée 7, 9 sont difficilement reproductibles, du fait par exemple de variations dimensionnelles dues à des retraits de la matière constitutive, consiste dans l'interposition, entre le sous-ensemble 1, 6 et la paroi intérieure de la poignée 7, 9 de graisse à base de silicones. On sait en effet que ces graisses sont conçues spécialement pour assurer une transmission thermique relativement satisfaisante. Elles présentent l'avantage de combler des interstices de formes variables. Il existe également des composés plastiques bons conducteurs de la chaleur utilisés dans l'industrie chimique, ainsi que des résines chargées de poudre

2

métallique présentant une plasticité suffisante lors de la mise en place du sous-ensemble 1, 6 dans la poignée 7, 9.

L'enveloppe 6 peut avoir tout profil nécessité par la configuration de la plaquette 1 ou de la structure de la poignée 7, 9, en particulier sa section peut être plus ou moins ouverte, par exemple en U, ou être composée de plusieurs éléments.

**Revendications**

1. Dissipateur thermique pour circuit électronique de fer à repasser, ce circuit comprenant au moins un élément générateur de chaleur tel qu'un triac (2) ou une résistance chutrice, et le dissipateur comprenant une enveloppe tubulaire (6) qui contient ledit circuit électronique, caractérisé en ce que ladite enveloppe tubulaire est métallique et est logée dans la poignée (7, 9) dudit fer, la section interne de cette poignée présentant une section homologue à la section externe de l'enveloppe tubulaire, et une liaison thermique (8) étant disposée entre ladite enveloppe et la poignée du fer.

2. Dissipateur thermique selon la revendication 1 caractérisé en ce que la liaison thermique comprend une feuille métallique gaufrée (8).

3. Dissipateur thermique selon la revendication 1, caractérisé en ce que la liaison thermique comprend une graisse à base de silicones.

4. Dissipateur thermique selon la revendication 1, caractérisé en ce que l'élément générateur de chaleur (2) est directement fixé à l'enveloppe tubulaire (6).

5. Fer à repasser comprenant un circuit électronique logé dans un dissipateur thermique conforme à l'une des revendications 1 à 4.

**Patentansprüche**

1. Wärmeableiter für eine Bügeleisen-Elektronikschaltung, die wenigstens ein wärmeabgebendes Element wie einen Triac (2) oder einen Vorwiderstand umfasst, wobei der Ableiter eine rohrförmige Hülle (6) umfasst, welche die Elektronikschaltung enthält, dadurch gekennzeichnet, dass die rohrförmige Hülle aus Metall und in dem Griff (7, 9) des Bügeleisens untergebracht ist, wobei der Innenquerschnitt dieses Griffes dem Aussenquerschnitt der rohrförmigen Hülle entspricht, und wobei eine thermische Verbindung (8) zwischen der Hülle und dem Griff des Bügeleisens angeordnet ist.

2. Wärmeableiter nach Anspruch 1, dadurch gekennzeichnet, dass die thermische Verbindung eine waffelförmig gestaltete Metallfolie (8) umfasst.

3. Wärmeableiter nach Anspruch 1, dadurch gekennzeichnet, dass die thermische Verbindung ein Fett auf Silikonbasis umfasst.

4. Wärmeableiter nach Anspruch 1, dadurch gekennzeichnet, dass das wärmeabgebende Element (2) direkt an der rohrförmigen Hülle (6) befestigt ist.

5. Bügeleisen mit einer Elektronikschaltung, die in einem Wärmeableiter nach einem der Ansprüche 1 bis 4 angeordnet ist.

**Claims**

1. A heat dissipator for the electronic circuit of a laundry iron, said circuit being provided with at least one heat-generating element such as a triac (2) or a dropping resistor, and the dissipator comprising a tubular casing (6) which contains said electronic circuit, characterized in that said tubular casing is metallic and housed within the handle (7, 9) of said laundry iron, the internal cross-section of said handle being similar in shape to the external cross-section of the tubular casing and a thermal bond (8) being arranged between said casing and said handle.

2. A heat dissipator according to claim 1, characterized in that the thermal bond comprises a corrugated metallic sheet.

3. A heat dissipator according to claim 1, characterized in that the thermal bond comprises a grease having a silicone base.

4. A heat dissipator according to claim 1, characterized in that the heat-generating element (2) is attached directly to the tubular casing (6).

5. A laundry iron comprising an electronic circuit housed within a heat dissipator according to one of claims 1 to 4.

FIG_1

FIG_2

0 064 424

0 064 424

FIG.3

7